# EUROPÄISCHE PATENTSCHRIFT

(11) **EP 0 650 608 B1**
(45) Veröffentlichungstag und Bekanntmachung des Hinweises auf die Patenterteilung: **09.12.1998**
(21) Anmeldenummer: 93912902.9
(22) Anmeldetag: 07.06.1993
(51) Int. Cl.: G03F 7/004, G03F 7/039, G03F 7/075, G03F 7/022

(54) **POSITIV-ARBEITENDES STRAHLUNGSEMPFINDLICHES GEMISCH UND DAMIT HERGESTELLTES AUFZEICHNUNGSMATERIAL**
POSITIVE-ACTING RADIATION-SENSITIVE MIXTURE AND RECORDING MATERIAL PRODUCED THEREWITH
MELANGE SENSIBLE AUX RAYONNEMENTS, A ACTION POSITIVE, ET MATERIAU D'ENREGISTREMENT FABRIQUE AVEC CE MELANGE

(30) Priorität: 13.07.1992 DE 4222968
(43) Veröffentlichungstag der Anmeldung: 03.05.1995
(73) Patentinhaber: Clariant GmbH, 65929 Frankfurt am Main (DE)
(72) Erfinder: WENGENROTH, Horst, D-56457 Westerburg (DE); RÖSCHERT, Horst, D-55437 Ober-Hilbersheim (DE); SPIESS, Walter, D-64807 Dieburg (DE); PAWLOWSKI, Georg, D-65187 Wiesbaden (DE); BUHR, Gerhard, D-61462 Königstein (DE)
(86) Internationale Anmeldenummer: EP9301430
(87) Internationale Veröffentlichungsnummer: WO9401805

(56) Entgegenhaltungen:
- EP-A- 146 411
- EP-A- 417 557
- EP-A- 505 094
- EP-A- 537 524
- DE-A- 4 124 426
- PATENT ABSTRACTS OF JAPAN vol. 014, no. 183 (P-1035)12. April 1990 & JP,A,2 029 750 (MITSUBISHI KASEI CORP) 31 January 1990
- DATABASE WPIL Section Ch, Week 9216, April 1992 Derwent Publications Ltd., London, GB; Class A05, AN 92-126589 & JP,A,4 068 355 (FUJI PHOTO FILM KK) 4 March 1992
- PATENT ABSTRACTS OF JAPAN vol. 012, no. 413 (P-780)2. November 1988 & JP,A,63 149 640 (KONICA CORP) 22 June 1988
- PATENT ABSTRACTS OF JAPAN vol. 012, no. 413 (P-780)2. November 1988 & JP,A,63 149 638 (KONICA CORP) 22 June 1988
- PATENT ABSTRACTS OF JAPAN vol. 012, no. 413 (P-780)2. November 1988 & JP,A,63 149 637 (KONICA CORP) 22 June 1988

## Beschreibung

Die Erfindung betrifft ein positiv-arbeitendes strahlungsempfindliches Gemisch mit
a) einem in Wasser unlöslichen, in wäßrig-alkalischer Lösung dagegen löslichen, zumindest quellbaren Bindemittel,
b) einer unter der Einwirkung aktinischer Strahlung eine starke Säure bildenden Verbindung und
c) einer Verbindung, die mindestens eine durch Säure spaltbare C-O-C- oder C-O-Si-Bindung enthält,
das insbesondere bei der Herstellung von elektronischen Bauteilen verwendet wird. Außerdem betrifft die Erfindung ein Aufzeichnungsmaterial mit einem Träger und einer strahlungsempfindlichen Schicht.

Die Miniaturisierung elektronischer Bauteile, für die eine Auflösung bis in den Bereich von weniger als 1 µm erforderlich ist, wurde im wesentlichen durch neue lithographische Techniken erzielt. Die Grenze der Auflösung ist dabei durch die Wellenlänge der zur Abbildung der Vorlage verwendeten Strahlung vorgegeben. Kurzwellige Strahlung, wie energiereiche UV-, Elektronen- und Röntgenstrahlung, ist bevorzugt. Dementsprechend müssen Gemische für Strahlung der jeweils verwendeten Wellenlänge ausreichend empfindlich sein. Einen Überblick über die an strahlungsempfindliche Gemische gestellten Forderungen gibt der Aufsatz von C.G. Willson "Organic Resist Materials - Theory and Chemistry [Introduction to Microlithography, Theory, Materials and Processing; Herausgeber: L.F. Thompson, C.G. Willson, M.J. Bowden; ACS Symp. Ser. **219** (1983) 87; American Chemical Society, Washington].

Bei der Herstellung von Positiv-Photoresists wurden zunächst Zweikomponenten-Gemische mit einem alkalilöslichen Harz und einer lichtempfindlichen Chinondiazid-Verbindung bevorzugt. Als alkalilösliches Harz wurde in der Regel ein Novolak eingesetzt. Die Lagerstabilität solcher Gemische ließ sich durch den Zusatz von primären, sekundären und tertiären Aminoverbindung oder Pyridin steigern (DE-A 37 38 603). Aufgrund ihrer Absorptionseigenschaften sind solche Gemische für lithographische Techniken, die den Einsatz von Strahlung mit einer Wellenlänge von weniger als 300 nm erfordern, jedoch kaum geeignet.

Eher geeignet für solche Techniken sind sogenannte "chemisch verstärkte" Systeme. Die chemische Verstärkung beruht darauf, daß zunächst durch die Bestrahlung aus einem "Photostarter" ein aktives Agens, in der Regel eine Brønsted-Säure, freigesetzt wird, das dann eine nachfolgende "Dunkelreaktion" katalysiert. Diese Systeme besitzen allgemein eine hohe Empfindlichkeit. Man unterscheidet zwischen Zweikomponenten- und Dreikomponenten-Systemen.

Ein Zweikomponenten-System besteht beispielsweise aus einem Photostarter und einem Polymer mit säurespaltbaren Bindungen. Das Polymer ist damit gleichzeitig Bindemittel und säurespaltbare Verbindung. In der umgebenden Luft etwa vorhandene Basen können in die Resistschicht eindringen und dort die photolytisch gebildete Säure neutralisieren. Eine Basenkonzentration in der Luft im parts-per-billion(ppb)-Bereich kann bereits Störungen verursachen (S.A. MacDonald et al., Proc. SPIE - Int. Soc. Opt. Eng. **1991** 1466 (Adv. Resist Technol. Process. 8) und O. Nalamasu et al., Conference Reprints, SPE - Regional Technical Conference; Photopolymers: Principles- Processes and Materials, Ellenville, New York, 28.-30.10.1991, Seite 225 - 234).

Dreikomponenten-Gemische der im einleitenden Absatz genannten Art sind bereits bekannt, z.B. aus der DE-A 39 30 087 und der DE-A 39 35 875.

Die unter Strahlungseinwirkung gebildete Säure spaltet die C-O-C- oder C-O-Si-Bindungen der Verbindung c). Die dadurch aus der Verbindung c) entstehenden Spaltprodukte bewirken eine erhöhte Löslichkeit des Gemisches in wäßrig-alkalischer Lösung. In einer auf ein Substrat aufgebrachten Schicht, die dieses Gemisch enthält oder daraus besteht, läßt sich auf diese Weise das Abbild einer Vorlage erzeugen. Um ein detailgetreues Bild zu erhalten, darf die Säure nicht von den bestrahlten in die unbestrahlten Schichtbereichen diffundieren. Diese Problematik wurde bereits erkannt und beschrieben (L. Schlegel et al.,J. Vac. Sci. Technol., B 9 (2) [1991] 278). Es wurde gefunden, daß das Ausmaß der Diffusion der Säure in der Polymermatrix von einer Reihe von Parametern abhängt. Von Bedeutung sind insbesondere die Temperaturen, bei denen ein pre-bake und ein post-exposure-bake stattfindet, sowie die Glas-Übergangstemperatur des polymeren Bindemittels. In den von L. Schlegel untersuchten Systemen diffundierte die Säure bis zu 520 nm weit. Diffusion tritt auf in der Zeitspanne zwischen der (bildmäßigen) Bestrahlung und der Entwicklung. Die Zeitspanne soll möglichst kurz sein, da sonst die vorlagengetreue Abbildung der Maske verlorengeht. Der Verarbeitungsspielraum ist somit gering. Es wurde versucht, der durch Diffusion entstehenden Bildverschlechterung durch den Einsatz von voluminösen oder polymergebundenen Säurebildnern zu begegnen. Doch dann werden häufig die säurespaltbaren Verbindungen nicht in ausreichendem Maße gespalten. Der Entwickler kann in den bestrahlten Bereichen die Schicht nicht mehr vollständig entfernen.

Die Verwendung von Additiven, wie Haftvermittlern, Netzmitteln, Farbstoffen, Sensibilisatoren und Weichmachern, in den oben beschriebenen "chemisch verstärkten" Gemischen ist bekannt. So ist in der DE-A 38 35 737 offenbart, daß durch den Zusatz von Hydroxymethansulfonyl-benzol Resiststrukturen mit einem höheren Wärmestand erhalten werden.

In der DE-A 41 24 426 ist ein lichtempfindliches Gemisch offenbart, das ein alkalilösliches Polymer, eine Verbindung, die unter der Einwirkung von aktinischer Strahlung Säure bildet, und eine organische Base enthält. Bei Bestrahlung bildet die photolytisch erzeugte Säure mit der organischen Base ein Salz, das die Löslichkeit des Gemisches in wäßrig-alkalischer Lösung erhöht. Säurebildende Verbindung und organische Base sind entsprechend in sämtlichen als Beispielen genannten Gemischen in gleichen Gewichtsmengen enthalten, so daß nach der Bestrahlung praktische keine freie Säure mehr vorliegt. Von dem Prinzip der "chemischen Verstärkung" wird in diesem Gemisch kein Gebrauch gemacht.

In dem Verfahren gemäß der EP-A 0 487 794 wird eine positiv-arbeitende oder eine negativ-arbeitende Photoresistschicht, die eine unter der Einwirkung von Strahlung säurebildende Verbindung enthält, vor oder nach der bildmäßigen Bestrahlung mit der Lösung eines Säurefängers (Imidazol oder ein tertiäres Amin) behandelt. Der Säurefänger dringt dabei in die Oberfläche der Resistschicht ein und bindet die photochemisch gebildete Säure in den weniger stark bestrahlten Randbereichen vollständig, während in den stark bestrahlten Bereichen noch genügend Säure übrigbleibt um eine Vernetzungs- bzw. Spaltungsreaktion zu katalysieren. Man erhält auf diese Weise nach post-exposure-bake und Entwicklung ein Resistbild mit einem verbesserten Flankenprofil.

In der EP-A 0 417 557 ist ein positiv-arbeitendes strahlungsempfindliches Gemisch beschrieben, das im wesentlichen ein unter der Einwirkung von Strahlung Säure bildendes α,α-Bis-sulfonyldiazomethan, eine Verbindung mit säurespaltbaren C-O-C- oder C-O-Si-Bindungen und ein in Wasser unlösliches, in wäßrig-alkalischer Lösung dagegen lösliches oder quellbares Bindemittel enthält. Darüber hinaus kann in dem Gemisch ein Farbstoff, insbesondere Kristallviolett, vorhanden sein.

In der EP-A 0 345 016, die die Priorität u.a. der Japanischen Anmeldung Nr. 88/180 624 (= JP-A 90/029 750) in Anspruch nimmt, die wiederum in den Patent Abstracts of Japan, Vol. 110, No. 183 (P 1053) vom 12.04.1990 referiert wird, ist ein positiv-arbeitendes, strahlungsempfindliches Gemisch zur Herstellung von Flachdruckplatten offenbart. Es umfaßt eine ortho-Naphthochinon-diazid-Verbindung, ein alkalilösliches Harz und einen sogenannten "Aktivator". Der Aktivator vermindert die Empfindlichkeit der lichtempfindlichen Schicht gegenüber der normalem Raumbeleuchtung, erhöht die Entwicklungstoleranz der bildmäßig belichteten Schicht und vermindert ein Schäumen des Entwicklers. Er kann ein Polyoxyethylen-polyoxypropylen-sorbitol-fettsäure-ester oder -ether sein. Auch dieses Gemisch kann einen Farbstoff, wie Kristallviolett, enthalten.

Im Derwent Abstract No. 92-126 589 (April 1992), in dem die JP-A 4-068 355 referiert wird, ist ebenfalls ein positiv-arbeitendes, strahlungsempfindliches Gemisch zur Herstellung von Flachdruckplatten offenbart. Es umfaßt einen ortho-Naphthochinon-diazid-4-sulfonsäureester, ein Novolak-Harz und ein spezielles nicht-ionisches oberflächenaktives Mittel. Letzteres kann ein Fettsäurealkanolamid [N,N-Bis-(2-hydroxy-ethyl)-fettsäureamid] sein. Das oberflächenaktive Mittel erhöht ebenfalls die Empfindlichkeit gegenüber der normalen Raumbeleuchtung.

Es bestand daher die Aufgabe "chemisch verstärkte" Gemische zu finden, die empfindlich sind gegenüber kurzwelliger Strahlung, insbesondere deep-UV(=DUV)-Strahlung, die Wiedergabe von Strukturdetails im Submikron-Bereich erlauben und dennoch einen relativ großen Verarbeitungsspielraum zulassen.

Die Aufgabe konnte überraschend durch den Zusatz von Stickstoff enthaltenden Verbindungen gelöst werden. Gegenstand der vorliegenden Erfindung ist somit ein strahlungsempfindliches Gemisch mit
a) einem in Wasser unlöslichen, in wäßrig-alkalischer Lösung dagegen löslichen, zumindest quellbaren Bindemittel,
b) einer unter der Einwirkung aktinischer Strahlung eine Säure bildenden Verbindung und
c) einer Verbindung, die mindestens eine durch Säure spaltbare C-O-C- oder C-O-Si-Bindung enthält,
dadurch gekennzeichnet, daß es zusätzlich 0,1 bis 70 mol-%, bezogen auf die maximale Menge an Säure, die aus der Verbindung b) theoretisch erzeugt werden kann, mindestens einer Verbindung mit mindestens einer Amin- oder Amidbindung enthält, wobei diese Verbindung 1,4-Diaza-bicyclo[2.2.2]octan, polymeres 2,2,4-Trimethyl-1,2-dihydro-chinolin, ein Terpolymer aus α-Methyl-styrol, N-Octadecyl-maleimid, N-(2,2,6,6-Tetramethyl-piperidin-4-yl)-maleimid, Dodecylamin, Decandisäure-bis-(2,2,6,6-tetramethyl-piperidin-4-yl-ester), Decandisäure-bis-(1,2,2,6,6-pentamethyl-piperidin-4-yl-ester) oder 8-Acetyl-3-dodecyl-7,7,9,9-tetramethyl-1,3,8-triaza-spiro[4.5]decan-2,4-dion ist.

Die stickstoffhaltigen Additive waren ursprünglich als Antioxidantien zugesetzt worden. Sie sollten verhindern, daß die aus Acetalen unter Säureeinwirkung hervorgehenden Aldehyde durch den Luftsauerstoff zu Carbonsäuren oxidiert werden, bewirkten jedoch überraschend eine höhere Auflösung und ließen einen breiteren Arbeitsspielraum zu.

Geeignet als Additive sind basische Stickstoffverbindungen, wie 1,4-Diaza-bicyclo[2.2.2]octan, daneben auch basische und nicht-basische Stickstoffverbindungen mit längeren hydrophoben, aliphatischen Resten. Beispiele für solche Verbindungen sind Dodecylamin, Decandisäure-bis-(2,2,6,6-tetramethyl-piperidin-4-yl-ester), Decandisäure-bis-(1,2,2,6,6-pentamethyl-piperidin-4-yl-ester) und 8-Acetyl-3-dodecyl-7,7,9,9-tetramethyl-1,3,8-triaza-spiro-[4.5]decan-2,4-dion. Allgemein bevorzugt sind Stickstoffverbindungen mit oberflächenaktiven Eigenschaften, d.h. mit Tensidcharakter, da diese sich offenbar besonders homogen in der Resistschicht verteilen. Hier ist insbesondere das Dodecylamin hervorzuheben. Auch polymere Stickstoffverbindungen sind geeignet. Hierzu seien polymeres 2,2,4-Trimethyl-1,2-dihydro-chinolin und ein Terpolymer aus α-Methyl-styrol, N-octadecyl-maleimid und N-(2,2,6,6-Tetramethyl-piperidin-4-yl)-maleimid genannt. Wie die Beispiele zeigen, können die Amin-Stickstoffatome auch in einer sekundären oder tertiären Amin-Struktur vorliegen. Die Amid-Stickstoffatome sind bevorzugt ein- oder zweifach substituiert, insbesondere mit Alkylgruppen.

Der Siedepunkt der Stickstoff-Additive liegt bei Normaldruck über 100 °C, bevorzugt über 150 °C, besonders bevorzugt über 180 °C. Die hohe Siedetemperatur ist notwendig, damit die homogene Verteilung des Additivs auch nach den thermischen Behandlungen erhalten bleibt und sich kein Konzentrationsgradient ausbildet.

Das erfindungsgemäße Gemisch zeichnet sich durch eine hohe Empfindlichkeit im DUV-Bereich (200 bis 300 nm) aus. Wird der Anteil an Additiv in dem Gemisch gesteigert, so nimmt die Strahlungsempfindlichkeit langsam ab, während der Verarbeitungsspielraum zunimmt.

Das polymere Bindemittel a) zeichnet sich insbesondere dadurch aus, daß es mit den übrigen Bestandteilen des Gemisches gut verträglich, d.h. homogen mischbar ist. Im Wellenlängenbereich von 190 bis 300 nm soll es eine möglichst geringe Eigenabsorption und damit eine hohe Transparenz besitzen. Beispiele für solche Bindemittel sind Homo- und Copolymere aus bzw. mit einem gegebenenfalls substituierten Hydroxystyrol, insbesondere aus bzw. mit 3- oder 4-Hydroxy-styrol oder 4-Hydroxy-3-methyl-styrol. Andere geeignete Monomere für die Herstellung der Bindemittel sind Hydroxyaryl-acrylate und N-Hydroxyarylacrylamide. Als Comonomere eignen sich auch Styrol, (Meth)acrylsäure-methacrylat und andere Monomere. Werden Silicium enthaltende Comonomere für die Herstellung der Bindemittel verwendet, so erhält man Bindemittel mit erhöhter Plasmaätzbeständigkeit. Die Transparenz solcher Bindemittel ist im DUV-Bereich sogar im allgemeinen höher, so daß eine noch höhere Auflösung erzielt werden kann. Verwendbar sind auch Homo- und Copolymere aus bzw. mit Maleinimid. Diese Bindemittel zeigen ebenfalls eine hohe Transparenz im DUV-Bereich. Als Comonomere sind hier gegebenenfalls substituiertes Styrol, Vinylether, Vinylester, Vinylsilane und (Meth)acrylsaureester besonders genannt. Copolymere aus Styrol und Maleinsäureanhydrid oder Maleinsäurehalbester zeigen allgemein ein erhöhte Löslichkeit in wäßrig-alkalischer Lösung. Es können auch mehrere Bindemittel gleichzeitig verwendet werden, solange sie mischbar sind und die optischen Qualitäten des Gemisches nicht verschlechtern. Bevorzugt enthalten die Gemische jedoch nur ein Bindemittel. Novolake kommen als alleinige Bindemittel nicht in Frage, da ihre Eigenabsorption im kurzwelligen Bereich zu hoch ist. Im Gemisch mit anderen Bindemitteln höherer Transparenz können sie jedoch verwendet werden. Die Novolake können dabei einen Anteil von bis zu 30 Gew.-%, insbesondere bis zu 20 Gew.-%, am Bindemittelgemisch ausmachen.

Der Anteil des Bindemittels oder Bindemittelgemisches a) beträgt etwa 1 bis 90 Gew.-%, vorzugsweise 50 bis 90 Gew.-%, jeweils bezogen auf das Gesamtgewicht der nichtflüchtigen Bestandteile des Gemisches.

Die säureerzeugende Verbindung b) kann aus einer großen Anzahl von Verbindungen gewählt werden. Auch Gemische verschiedener säureerzeugender Verbindungen kommen in Frage. Geeignet sind besonders Verbindungen, die unter der Einwirkung aktinischer Strahlung eine starke Säure hervorbringen. Dies sind in erster Linie Diazonium-, Phosphonium-, Sulfonium- und Iodoniumsalze, Halogenverbindungen, ortho-Chinondiazid-sulfonylhalogenide, ortho-Chinondiazidsulfonsäureester und Organometall-Organohalogen-Kombinationen. Die genannten Oniumsalze werden in der Regel in Form ihrer in organischen Lösemitteln löslichen Salze eingesetzt, meist als Tetrafluorborate, Hexafluorphosphate, Hexafluorantimonate oder Hexafluorarsenate. Von den Halogenverbindungen sind mit Trichlormethyl- und/oder Tribrommethylgruppen substituierte Triazine, Oxazole, Oxadiazole, Thiazole und 2-Pyrone bevorzugt. Daneben eignen sich auch halogenierte, insbesondere chlorierte und bromierte Aromaten als Säurebildner. Aufgrund ihrer hohen Empfindlichkeit und ihrer hohen Transparenz im DUV-Bereich sind α,α'-Bis-sulfonyl-diazomethane und α-Sulfonyl-α'-carbonyl-diazomethane als Säurebildner besonderes geeignet. Durch Zusatz von Photosensibilisatoren kann die Effektivität der säurebildenen Verbindungen in vielen Fällen noch erhöht werden.

Der Anteil der säurebildenden Verbindungen beträgt im allgemeinen 0,01 bis 7 Gew.-%, bevorzugt 0,05 bis 5 Gew.-%, jeweils bezogen auf das Gesamtgewicht der nichtflüchtigen Bestandteile des Gemisches.

Die säurespaltbaren Verbindungen c) in dem erfindungsgemäßen Gemisch werden vorteilhaft aus den folgenden Verbindungsklassen gewählt:
(a) Verbindungen mit mindestens einer Orthocarbonsäureester- und/oder Carbonsäureamidacetalgruppe, wobei die Verbindungen auch polymeren Charakter haben und die genannten Gruppen in der Hauptkette oder seitenständig auftreten können,
(b) oligomere oder polymere Verbindungen mit wiederkehrenden Acetal- und/oder Ketalgruppen in der Hauptkette,
(c) Verbindungen mit mindestens einer Enolether- oder N-Acyliminocarbonatgruppe,
(d) cyclische Acetale oder Ketale von β-Ketoestern oder -amiden,
(e) Verbindungen mit Silylethergruppen,
(f) Verbindungen mit Silylenolethergruppen,
(g) Monoacetale bzw. Monoketale von Aldehyden bzw. Ketonen, deren Löslichkeit im Entwickler zwischen 0,1 und 100 g/l beträgt,
(h) Ether auf der Basis tertiärer Alkohole,
(i) Carbonsäureester und Carbonate, deren Alkoholkomponente ein tertiärer Alkohol, ein Allylalkohol oder ein Benzylalkohol ist, und
(j) N,O-Acetale, insbesondere N,O-Polyacetale.

Es können auch Mischungen der vorgenannten säurespaltbaren Materialien eingesetzt werden. Bevorzugt ist allerdings ein säurespaltbares Material, das nur einem der obengenannten Klassen zugeordnet werden kann. Besonders bevorzugt sind Verbindungen mit mindestens einer durch Säure spaltbaren C-O-C-Bindung, d. h. besonders bevorzugt sind die Verbindungsklassen (a), (b), (g), (i) und (j). Von den Verbindungen der Klasse (b) sind besonders die polymeren Acetale hervorzuheben; von den säurespaltbaren Verbindungen des Typs (g) insbesondere diejenigen, die sich von Aldehyden bzw. Ketonen mit einem Siedepunkt über 150 °C, vorzugsweise über 200 °C, ableiten. Besonders bevorzugt sind die N,O-Polyacetale des Typs (j).

Die säurespaltbare Verbindung bzw. das Gemisch säurespaltbarer Verbindungen hat einen Anteil von 1 bis 50 Gew.-%, bevorzugt 5 bis 35 Gew.-%, jeweils bezogen auf das Gesamtgewicht der nichtflüchtigen Bestandteile des Gemisches.

Das erfindungsgemäße Gemisch kann schließlich noch Farbstoffe, Pigmente, Weichmacher, Netzmittel und Verlaufmittel enthalten. Um spezielle Erfordernisse, wie Flexibilität, Haftung und Glanz, zu erfüllen, kann es noch weitere Bestandteile, wie Polyglykole, Celluloseether, insbesondere Ethylcellulose, umfassen.

Soll ein Substrat beschichtet werden, so wird das erfindungsgemäße strahlungsempfindliche Gemisch zweckmäßig in einem Lösemittel oder in einer Kombination von Lösemitteln gelöst. Die Wahl des Lösemittels oder Lösemittelgemisches hängt letztlich ab von dem angewandten Beschichtungsverfahren, der gewünschten Schichtdicke und den Trocknungsbedingungen. Ebenso müssen die Lösemittel unter den angewendeten Bedingungen gegenüber den übrigen Schichtbestandteilen chemisch inert sein. Besonders geeignete Lösemittel sind Glykole, wie Ethylenglykol, Glykolether, wie Glykolmonomethylether und Glykoldimethylether, Glykolmonoethylether und Glykoldiethylether, Propylenglykolmonomethylether, Glykolether-ester, wie Ethylenglykol-methylether-acetat und Propylenglykolmethylether-acetat, Ester, wie Ethylacetat, Butylacetat, Butyrolacton und Hydroxyethylacetat, Ether, wie Tetrahydrofuran und Dioxan, Ketone, wie Butanon, 4-Methyl-pentan-2-on, Cyclopentanon und Cyclohexanon, Carbonsäureamide, wie N,N-Dimethyl-formamid, N,N-Dimethylacetamid und N-Methyl-pyrrolidon, sowie Phosphorsäureamide, wie Hexa-N-methyl-phosphorsäuretriamid. Von diesen sind die Glykolether, aliphatischen Ester und Ketone bevorzugt.

Die mit den genannten Lösemitteln hergestellte Lösung hat in der Regel einen Feststoffgehalt von 5 bis 60 Gew.-%, vorzugsweise 10 bis 40 Gew.-%.

Gegenstand der Erfindung ist schließlich auch ein strahlungsempfindliches Aufzeichnungsmaterial, das im wesentlichen aus einem Trägermaterial (Substrat) und einer darauf befindlichen strahlungsempfindlichen Schicht besteht und dadurch gekennzeichnet ist, daß die Schicht aus dem erfindungsgemäßen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Hierzu zählen besonders thermisch oxidierte und/oder mit Aluminium beschichtete Siliciumsubstrate, die auch dotiert sein können, daneben auch Substrate aus Siliciumnitrid, Galliumarsenid und Indiumphosphid. Weiterhin kommen die zur Herstellung von Flüssigkristalldisplays bekannten Substrate, wie Glas und Indium-Zinnoxid. Als Substrat dienen können ferner auch Metallplatten und -folien, insbesondere solche aus Aluminium, Kupfer und Zink. Schließlich sind auch Bimetall- und Trimetallfolien, elektrisch nichtleitende Folien, die mit Metallen bedampft sind, sowie Papier geeignet. Die Substrate können thermisch vorbehandelt, oberflächlich aufgerauht, angeätzt oder zur Veränderung der Oberfläche, z.B. zur Verbesserung der Hydrophilie, mit speziellen Chemikalien behandelt sein.

Gegebenenfalls wird ein Haftvermittler eingesetzt. Bei Silicium- und Siliciumdioxid-Substraten kommen hierfür besonders Aminosilane, wie 3-Aminopropyl-triethoxy-silan und Hexamethyldisilazan, in Frage.

Das erfindungsgemäße Gemisch kann jedoch auch zur Herstellung von photomechanischen Aufzeichnungsschichten, wie Druchformen für den Hochdruck, Flachdruck und Siebdruck, sowie von Reliefkopien eingesetzt werden. Geeignete Substrate hierfür sind insbesondere Aluminiumplatten, die anodisch oxidiert, gekörnt und/oder silikatisiert sein können. Zinkplatten, gegebenenfalls verchromte Stahlplatten, Kunststoffolien und Papier können Verwendung finden.

Das erfindungsgemäße Aufzeichnungsmaterial wird mit aktinischer Strahlung bildmäßig bestrahlt. Als Strahlungsquellen eignen sich besonders Metallhalogenidlampen, Kohlebogenlampen und Xenon-Qecksilberdampflampen. Es kann auch mit Laser-, Elektronen- oder Röntgenstrahlen bestrahlt werden. Strahlung mit einer Wellenlänge von 190 bis 260 nm wird bevorzugt eingesetzt. Zur Erzeugung solcher Strahlung eignen sich besonders Xenon-Quecksilberdampflampen. Daneben sind auch Excimerlaser, besonders KrF- und ArF-Excimerlaser, die Strahlung mit einer Wellenlänge von 248 bzw. 193 nm emittieren, geeignet.

Die Dicke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Das erfindungsgemäße Aufzeichnungsmaterial läßt sich herstellen, indem das erfindungsgemäße Gemisch auf ein Substrat durch Aufsprühen, Fließbeschichten, Walzen, Schleuderbeschichten oder Tauchbeschichten aufgebracht wird. Das für den Beschichtungsprozeß in der Regel erforderliche Lösemittel wird anschließend entfernt, gewöhnlich durch Verdampfen. Das beschichtete Substrat kann dazu auf Temperaturen von bis zu 150 °C erhitzt werden. Das Gemisch kann aber auch auf einen Zwischenträger aufgebracht werden, von dem es dann unter Anwendung von Druck und erhöhter Temperatur auf das endgültige Substrat übertragen wird. Als Zwischenträger können grundsätzlich alle genannten Substrate eingesetzt werden.

Das bestrahlte Aufzeichnungsmaterial wird zur Freilegung des positiven Bildes anschließend mit einem Entwickler behandelt. Üblicherweise wird hierzu ein wäßrig-alkalischer Entwickler eingesetzt, der bevorzugt metallionen-frei ist. Als metallionen-freier Entwickler ist eine wäßrige Tetraalkyl-, speziell Tetramethyl-, -ammoniumhydroxid-Lösung, bevorzugt. Der Entwickler hat im allgemeinen einen Feststoffgehalt von 0,1 bis 15 Gew.-%, bevorzugt 0,5 bis 5 Gew.-%. Um die Ablösung der bestrahlten Schichtbereiche von dem Substrat zu fördern, kann der Entwickler noch geringere Mengen eines Netzmittels enthalten.

Die entwickelten Resiststrukturen können noch nachgehärtet werden. Dies wird im allgemeinen durch Erhitzen auf einer "hot-plate" auf eine Temperatur unterhalb der Fließtemperatur und anschließendes ganzflächiges Belichten mit der UV-Strahlung (200 bis 250 nm) einer Xenon-Quecksilberdampflampe erreicht. Durch die Nachhärtung werden die Resiststrukturen so vernetzt, daß sie im allgemeinen bis zu Temperaturen von über 200 °C stabil sind und nicht zu fließen beginnen. Die Nachhärtung kann auch ohne Temperaturerhöhung allein durch Einwirkung von UV-Strahlung erfolgen.

Die nachstehend beschriebenen Beispiele illustrieren die Erfindung, sollen aber keine Einschränkung bewirken. Gt steht im folgenden für Gewichtsteile.

### Beispiele 1 bis 18

Ein strahlungsempfindliches Gemisch bestehend aus

| | |
|---|---|
| 69 Gt | Poly(4-hydroxy-3-methyl-styrol) (M_{W}: 15 000), |
| 29 Gt | Poly-N,O-Acetal hergestellt aus Benzaldehyd und N-Propyl-carbamidsaure-(2-hydroxy-ethyl-ester) und |
| 2 Gt | Bis-(4-chlor-benzolsulfonyl)-diazomethan |

wurde in Propylenglykol-monomethylether-acetat gelöst, so daß eine 20 gew.-%ige Lösung erhalten wurde. Teile dieser Lösung wurden mit den folgenden Additiven versetzt:

### Additiv Nr.

1 1,4-Diaza-bicyclo[2.2.2]octan (^{(R)}Dabco),
2 Dodecylamin,
3 Decandisäure-bis-(2,2,6,6-tetramethyl-piperidin-4-yl-ester) (^{(R)}Tinuvin 770 DF),
4 Decandisäure-bis-(1,2,2,6,6-pentamethyl-piperidin-4-yl-ester) (^{(R)}Tinuvin 765),
5 8-Acetyl-3-dodecyl-7,7,9,9-tetramethyl-1,3,8-triazaspiro[4.5]decan-2,4-dion (^{(R)}Tinuvin 440),
6 polymeres 2,2,4-Trimethyl-1,2-dihydro-chinolin (^{(R)}Lowinox ACP),
7 Terpolymer aus α-Methyl-styrol, N-Octadecyl-maleimid und N-(2,2,6,6-Tetramethyl-piperidin-4-yl)-maleimid (^{(R)}Lowilite 62).

Die Photoresistlösungen mit oder ohne Zusatz von Additiven wurden dann durch ein Filter mit einer Porenweite von 0,2 µm filtriert und anschließend auf einen Siliciumwafer mit einem Durchmesser von 7,62 cm Durchmesser aufgeschleudert. Nach dem Trocknen auf der hot plate (1 min bei 110 °C) betrug die Dicke der strahlungsempfindlichen Schicht 1,07 µm.

Die in dieser Weise beschichteten Wafer wurden durch eine Graukeilmaske vom Typ Optoline mit 248 nm UV-Strahlung einer Xenon-Quecksilberdampflampe mit einer Energie von 30 mJ/cm² bestrahlt. Eine Minute nach Ende der Bestrahlung wurden die Wafer auf einer hot plate erwärmt (post-exposure-bake; 1 min bei 60 °C). Nach weiteren 10, 30 oder 60 Minuten wurden die beschichteten Wafer dann mit einer 0,27 n wäßrigen Tetramethylammoniumhydroxid-Lösung 60 s lang entwickelt.

Anschließend wurde die Schichtdicke in den durch die jeweiligen Stufen des Graukeils bestrahlten Bereichen gemessen. Aus diesen Werten wurde die zur vollständigen Entwicklung der Schicht notwendige Energiedosis ermittelt.

Es wurde dann untersucht, wie sich die zur vollständigen Entwicklung der Schicht notwendige Energiedosis ändert, wenn der zeitliche Abstand zwischen post-exposure-bake und Entwicklung variiert wird (Tabelle 1). Weiter wurde der Einfluß der Additive auf die Kontrastwerte ermittelt bei Standzeiten zwischen post-exposure-bake und Entwicklung von 10 min und von 60 min. Die Definition für den Kontrast einer Positiv-Resist-Schicht ist z.B. angegeben bei L.F. Thompson et al., Introduction to Microlithography; Theory, Materials, and Processing, ACS Symposium Series **219** [1983] 170. Die Ergebnisse sind in Tabelle 2 zusammengefaßt.

**Tabelle 1**

| Beispiel | Additiv | Menge an Additiv | Zur vollständigen Entwicklung benötigte Energiedosis (mJ/cm²) bei einem zeitlichen Abstand zwischen post-exposure bake und Entwicklung von | | | |
|---|---|---|---|---|---|---|
| Nr. | Nr. | Gt | 10 min | 30 min | 60 min | 2 Tage |
| 1 | 1 | 0,3 | 8,6 | 8,6 | 7,3 | 4,2 |
| 2 | 1 | 2,9 | 15,4 | 13,8 | | |
| 3 | 2 | 0,5 | 7,5 | 6,8 | 5,9 | |
| 4 | 2 | 4,7 | 12,3 | 12,1 | 12,3 | |
| 5 | 3 | 1,2 | 7,5 | 7,5 | | |
| 6 | 4 | 1,3 | 7,7 | 7,4 | | |
| 7 | 4 | 13 | 12,6 | | 10,8 | |
| 8 | 5 | 1,1 | 9,2 | 9,1 | | |
| 9 | 5 | 10,8 | 13,4 | | 11,0 | |
| 10 | 6 | 0,4 | 7,5 | 6,6 | 6,0 | |
| 11 | 6 | 21 | 15,4 | | 12,6 | |
| 12 | 7 | 2,1 | 7,5 | 6,7 | 6,1 | |
| 13V* | - | - | 9,0 | 7,7 | 7,0 | 3,6 |

| | | | | | | |
|---|---|---|---|---|---|---|
| * Vergleichsbeispiel | | | | | | |

Die Werte zeigen, daß mit den erfindungsgemäßen Gemischen wesentlich längere Standzeiten möglich werden. Dies wird auf eine verminderte Diffusion der unter der Einwirkung der Strahlung gebildeten Säure in die nichtbestrahlten Bereiche der Schicht zurückgeführt. Die Dunkelreaktion ist somit verlangsamt.

**Tabelle 2**

| Beispiel | Additiv | Menge an Additiv | Einfluß der Kontrastwerte bei Änderung der Standzeit | |
|---|---|---|---|---|
| Nr. | Nr. | Gt | Kontrastwert 60 min | Kontraständerung 10/60 min in % |
| 1 | 1 | 0,3 | 9,3 | + 55 |
| 3 | 2 | 0,5 | 8,7 | + 81 |
| 5 | 3 | 1,2 | 8,9 | + 44 |
| 6 | 4 | 1,3 | 9,4 | + 45 |
| 10 | 6 | 0,4 | 9,4 | + 71 |
| 12 | 7 | 2,1 | 9,7 | + 70 |
| 14 | 5 | 27,1 | 8,2 | +156 |
| 13V* | - | - | 7,8 | + 13 |

| | | | | |
|---|---|---|---|---|
| * Vergleichsbeispiel | | | | |

Die folgenden Beispiele zeigen, wie sich die zur vollständigen Entwicklungs notwendige Energiedosis ändert, wenn der zeitliche Abstand zwischen Bestrahlung und thermischer Nachbehandlung (post-exposure-bake) verändert wird. Der zeitliche Abstand zwischen post-exposure-bake und Entwicklung wurde bei diesen Beispielen mit 1 min konstant gehalten. Die Ergebnisse sind in Tabelle 3 zusammengefaßt.

**Tabelle 3**

| Beispiel | Additiv | Menge an Additiv | Zur vollständigen Entwicklung benötigte Energiedosis (mJ/cm2) bei einem zeitlichen Abstand zwischen Bestrahlung und post-exposure bake von | | |
|---|---|---|---|---|---|
| Nr. | Nr. | Gt | 1 min | 30 min | 60 min |
| 15 | 2 | 0,5 | 8,5 | 7,4 | 7,1 |
| 16 | 2 | 4,7 | 12,2 | 12,2 | 10,0 |
| 17 | 4 | 1,3 | 8,4 | 7,4 | 7,4 |
| 18 | 4 | 13 | 14,0 | 11,9 | 11,2 |
| 13V* | - | - | 8,3 | 7,1 | 6,6 |

| | | | | | |
|---|---|---|---|---|---|
| * Vergleichsbeispiel | | | | | |

### Beispiel 19

Ein strahlungsempfindliches Gemisch bestehend aus

| | |
|---|---|
| 69 Gt | Poly(4-hydroxy-3-methyl-styrol) (M_{W}: 15 000), |
| 29 Gt | Poly-N,O-Acetal hergestellt aus Benzaldehyd und N-Propyl-carbamidsäure-(2-hydroxy-ethyl-ester), |
| 2 Gt | Bis-(4-chlor-benzolsulfonyl)-diazomethan und |
| 0,5 Gt | 8-Acetyl-3-dodecyl-7,7,9,9-tetramethyl-1,3,8-triaza-spiro[4.5]decan-2,4-dion |

wurde in Propylenglykol-monomethylether-acetat gelöst, so daß eine 20 gew.-%ige Lösung erhalten wurde. Die Lösung wurde wie oben beschrieben filtriert und auf einen Silicium-Wafer mit einem Durchmesser von 7,62 cm (3 Zoll) aufgeschleudert. Nach dem Trocknen auf der hot plate (1 min bei 120 °C) betrug die Dicke der strahlungsempfindlichen Schicht 1,07 µm.

Der so beschichtete Wafer wurde anschließend mit Hilfe einer Maske bildmäßig mit 248 nm UV-Strahlung bestrahlt (KrF-Excimerlaser). Die Bestrahlungsdosis betrug 25 mJ/cm². Die Standzeit zwischen Bestrahlung und post-exposure-bake (60 °C, 1 min) betrug 30 min. Nach der thermischen Nachbehandlung wurde der Wafer mit einer 0,27 n wäßrigen Tetramethylammoniumhydroxid-Lösung entwickelt. Die rasterelektronenmikroskopische Untersuchung zeigte, daß Strukturen bis herab zu 0,35 µm lines and spaces aufgelöst waren.

### Beispiel 20 (Vergleichsbeispiel)

Es wurde ein Resistgemisch wie im vorangehenden Beispiel verwendet, jedoch ohne den Zusatz des Additivs. Die Bestrahlungsdosis betrug in diesem Fall 17 mJ/cm². Die rasterelektronenmikroskopische Untersuchung zeigte, daß mit diesem Gemisch eine Auflösung von nicht mehr als 0,5 µm erreicht werden kann.

### Beispiel 21

Ein strahlungsempfindliches Gemisch bestehend aus

| | |
|---|---|
| 69 Gt | Poly(4-hydroxy-3-methyl-styrol) (M_{W}: 15 000), |
| 29 Gt | Poly-N,O-Acetal hergestellt aus Benzaldehyd und N-Propyl-carbamidsäure-(2-hydroxy-ethyl-ester), |
| 2 Gt | Bis-(4-chlor-benzolsulfonyl)-diazomethan und |
| 0,215 Gt | 8-Acetyl-3-dodecyl-7,7,9,9-tetramethyl-1,3,8-triaza-spiro[4.5]decan-2,4-dion |

wurde in Propylenglykol-monomethylether-acetat gelöst, so daß eine 20 gew.-%ige Lösung erhalten wurde. Die Lösung wurde wie oben beschrieben filtriert und auf einen Silicium-Wafer mit einem Durchmesser von 7,62 cm (3 Zoll) aufgeschleudert. Nach dem Trocknen auf der hot plate (1 min bei 120 °C) betrug die Dicke der strahlungsempfindlichen Schicht 1,07 µm.

Der so beschichtete Wafer wurde anschließend mit Hilfe einer Maske bildmäßig mit 248 nm UV-Strahlung bestrahlt (KrF-Excimerlaser). Die Bestrahlungsdosis betrug 25 mJ/cm². Die Standzeit zwischen Bestrahlung und post-exposure-bake (60 °C, 1 min) betrug 30 min. Nach der thermischen Nachbehandlung wurde der Wafer mit einer 0,27 n wäßrigen Tetramethylammoniumhydroxid-Lösung 1 min lang bei 21 °C entwickelt. Mit Hilfe eines Rasterelektronenmikroskops wurde die Breite der Linien und Gräben bestimmt. Bei freistehenden Linien wurde der Abstand der Fußpunkte bestimmt und bei Gräben der Abstand der oberen Resistränder.

### Beispiel 22 (Vergleichsbeispiel)

Zum Vergleich wurden Resiststrukturen vermessen, die mit dem vorangehend beschriebenen Resistgemisch, jedoch ohne Zusatz eines Additivs, erhalten worden waren. Gegenüberstellung der Beispiele 21 und 22 in Tabelle 4.

**Tabelle 4**

| Normalmaßstab in µm | Abweichung in % | | | |
|---|---|---|---|---|
| | Linien | | Gräben | |
| Beispiele | 21 | 22 | 21 | 22 |
| 0,50 | 9 | 40 | 10 | 31 |
| 0,45 | 12 | 47 | 11 | 36 |
| 0,40 | 15 | 53 | 16 | 42 |
| 0,35 | 20 | 61 | 21 | 47 |

## Patentansprüche

1. Strahlungsempfindliches Gemisch mit
a) einem in Wasser unlöslichen, in wäßrig-alkalischer Lösung dagegen löslichen, zumindest quellbaren Bindemittel,
b) einer unter der Einwirkung aktinischer Strahlung eine Säure bildenden Verbindung und
c) einer Verbindung, die mindestens eine durch Säure spaltbare C-O-C- oder C-O-Si-Bindung enthält,
dadurch gekennzeichnet, daß es zusätzlich 0,1 bis 70 mol-%, bezogen auf die maximale Menge an Säure, die aus der Verbindung b) theoretisch erzeugt werden kann, mindestens einer Verbindung mit mindestens einer Amin- oder Amidbindung enthält, wobei diese Verbindung 1,4-Diaza-bicyclo[2.2.2]octan, polymeres 2,2,4-Trimethyl-1,2-dihydro-chinolin, ein Terpolymer aus α-Methyl-styrol, N-Octadecyl-maleimid, N-(2,2,6,6-Tetramethyl-piperidin-4-yl)-maleimid, Dodecylamin, Decandisäure-bis-(2,2,6,6-tetramethyl-piperidin-4-yl-ester), Decandisäure-bis-(1,2,2,6,6-pentamethyl-piperidin-4-yl-ester) oder 8-Acetyl-3-dodecyl-7,7,9,9-tetramethyl-1,3,8-triaza-spiro[4.5]decan-2,4-dion ist.

2. Strahlungsempfindliches Gemisch gemäß Anspruch 1, dadurch gekennzeichnet, daß der Gehalt an Verbindungen, die mindestens ein Stickstoffatom in einer Amin- oder Amidbindung enthalten, 0,1 bis 70 mol-%, bevorzugt 0,5 bis 50 mol-%, besonders bevorzugt 1 bis 40 mol-%, bezogen auf die maximale Menge an Säure, die aus der Verbindung b) theoretisch erzeugt werden kann, beträgt.

3. Strahlungsempfindliches Gemisch gemäß Anspruch 1 oder 2, dadurch gekennzeichnet, daß der Anteil des Bindemittels oder Bindemittelgemisches a) etwa 1 bis 90 Gew.-%, bevorzugt 50 bis 90 Gew.-%, beträgt, jeweils bezogen auf das Gesamtgewicht der nichtflüchtigen Bestandteile des Gemisches.

4. Strahlungsempfindliches Gemisch gemäß einem oder mehreren der Ansprüche 1 bis 3, dadurch gekennzeichnet, daß der Anteil der säurebildenden Verbindung(en) b) 0,01 bis 7 Gew.-%, bevorzugt 0,05 bis 5 Gew.-%, beträgt, jeweils bezogen auf das Gesamtgewicht der nichtflüchtigen Bestandteile des Gemisches.

5. Strahlungsempfindliches Gemisch gemäß einem oder mehreren der Ansprüche 1 bis 4, dadurch gekennzeichnet, daß der Anteil der säurespaltbaren Verbindung(en) 1 bis 50 Gew.-%, bevorzugt 5 bis 35 Gew.-%, beträgt, jeweils bezogen auf das Gesamtgewicht der nichtflüchtigen Bestandteile des Gemisches.

6. Strahlungsempfindliches Aufzeichnungsmaterial mit einem Trägermaterial und einer darauf befindlichen strahlungsempfindlichen Schicht, dadurch gekennzeichnet, daß die Schicht aus dem erfindungsgemäßen Gemisch gemäß einem oder mehreren der Ansprüche 1 bis 5 besteht.

## Claims

1. A radiation-sensitive mixture comprising
a) a binder which is insoluble in water but soluble or at least swellable in aqueous alkaline solution,
b) a compound which forms an acid under the action of actinic radiation and
c) a compound which contains at least one C-O-C or C-O-Si bond which can be cleaved by an acid,
wherein said mixture additionally contains 0.1 to 70 mol %, based on the maximum amount of acid which can theoretically be produced from the compound b), of at least one compound having at least one amine or amide bond, this compound being 1,4-diazabicyclo-[2.2.2]octane, polymeric 2,2,4-trimethyl-1,2-dihydroquinoline, a terpolymer of α-methylstyrene, N-octadecylmaleimide, N-(2,2,6,6-tetramethylpiperidin-4-yl)-maleimide, dodecylamine, bis-(2,2,6,6-tetramethylpiperidin-4-yl) decanedioate, bis-(1,2,2,6,6-pentamethylpiperidin-4-yl) decanedioate or 8-acetyl-3-dodecyl-7,7,9,9-tetramethyl-1,3,8-triazaspiro[4.5]decane-2,4-dione.

2. The radiation-sensitive mixture as claimed in claim 1, wherein the content of compounds which contain at least one nitrogen atom in an amine or amide bond is 0.1 to 70 mol %, preferably 0.5 to 50 mol %, particularly preferably 1 to 40 mol %, based on the maximum amount of acid which can theoretically be produced from the compound b).

3. The radiation-sensitive mixture as claimed in claim 1 or 2, wherein the proportion of the binder or binder mixture a) is about 1 to 90% by weight, preferably 50 to 90% by weight, based in each case on the total weight of the nonvolatile components of the mixture.

4. The radiation-sensitive mixture as claimed in one or more of claims 1 to 3, wherein the proportion of the acid-forming compound or compounds b) is 0.01 to 7% by weight, preferably 0.05 to 5% by weight, based in each case on the total weight of the nonvolatile components of the mixture.

5. The radiation-sensitive mixture as claimed in one or more of claims 1 to 4, wherein the proportion of the acid-cleavable compound or compounds is 1 to 50% by weight, preferably 5 to 35% by weight, based in each case on the total weight of the nonvolatile components of the mixture.

6. A radiation-sensitive recording material having a substrate and a radiation-sensitive coating present thereon, wherein the coating comprises the mixture according to the invention, as claimed in one or more of claims 1 to 5.

## Revendications

1. Mélange sensible au rayonnement avec
a) un liant insoluble dans l'eau, par contre soluble ou au moins gonflable en milieu aqueux alcalin,
b) un composé formant un acide sous l'effet de rayonnement actinique et
c) un composé qui contient au moins une liaison C-O-C ou C-O-Si dissociable par un acide,
caractérisé en ce qu'il contient en plus de 0,1 à 70 % en moles par rapport à la quantité maximale d'acide que l'on peut obtenir théoriquement à partir du composé b), d'au moins un composé avec au moins une liaison amine ou amide, ce composé étant le 1,4-diaza-bicyclo[2.2.2]-octane, la 2,2,4-triméthyl-1,2-dihydro-quinoléine polymère, un terpolymère de α-méthylstyrène, le N-octadécyl-maléimide, le N-(2,2,6,6-tétraméthylpipéridin-4-yl)-maléimide, la dodécylamine, l'ester de bis-(1,2,2, 6,6-pentaméthyl-pipéridin-4-yle) de diacide décanoïque ou la 8-acétyl-3-dodécyl-7,7,9,9-tétraméthyl-1,3,8-triaza-spiro[4.5]décane-2,4-dione.

2. Mélange sensible au rayonnement selon la revendication 1, caractérisé en ce que la teneur en composés qui contiennent au moins un atome d'azote sous forme d'une liaison amine ou amide va de 0,1 à 70 % en moles, de préférence de 0,5 à 50 % en moles, de manière particulièrement préférée de 1 à 40 % en moles par rapport à la quantité maximale d'acide, que l'on peut théoriquement obtenir à partir du composé b).

3. Mélange sensible au rayonnement selon la revendication 1 ou 2, caractérisé en ce que le taux en liant ou en mélange de liant a) est d'environ 1 à 90 % en poids, de préférence de 50 à 90 % en poids, à chaque fois par rapport au poids total des constituants non volatils du mélange.

4. Mélange sensible au rayonnement selon une ou plusieurs des revendications 1 à 3, caractérisé en ce que le taux en composé formateur d'acide est de 0,01 à 7 % en poids, de préférence de 0,05 à 5 % en poids, à chaque fois par rapport au poids total des constituants non volatils du mélange.

5. Mélange sensible au rayonnement selon une ou plusieurs des revendications 1 à 4, caractérisé en ce que le taux en composé(s) dissociable(s) par un acide est de 1 à 50 % en poids, de préférence de 5 à 35 % en poids, à chaque fois par rapport au poids total des constituants non volatils du mélange.

6. Matière d'enregistrement sensible au rayonnement avec une matière de support et une couche sensible au rayonnement déposée sur celle-ci, caractérisée en ce que la couche est constituée d'un mélange conforme à l'invention selon une ou plusieurs des revendications 1 à 5.
